# EUROPEAN PATENT SPECIFICATION

(11) **EP 0 509 175 B1**
(45) Date of publication and mention of the grant of the patent: **19.06.1996**
(21) Application number: 91309804.2
(22) Date of filing: 23.10.1991
(51) Int. Cl.: H03J 1/00

(54) **Preset tuner**
Tuner mit Voreinstellung
Tuner à présélection

(30) Priority: 16.04.1991 JP 84200/91
(43) Date of publication of application: 21.10.1992
(73) Proprietor: PIONEER ELECTRONIC CORPORATION, Meguro-ku Tokyo 153 (JP)
(72) Inventor: Kobayashi, Hiroshi, c/o Pioneer Electronic Corp., Oaza Yamada Kawagoe-shi, Saitama (JP)
(74) Representative: Brunner, Michael John

(56) References cited:
- EP-A- 0 403 744
- DE-A- 3 149 409
- GB-A- 2 050 096
- US-A- 4 365 349
- US-A- 4 783 847

## Description

The present invention relates to a tuner in which frequency data for channel selection can be preset in a memory.

In a preset tuner, a local oscillation circuit at a front end is constituted by a phase locked loop (PLL) circuit, and a preset key and a storage position in a memory are provided for every channel, so that frequency data indicating a reception frequency preset in a programmable divider of the PLL circuit is written into a corresponding storage position upon operation of a preset key corresponding to a channel, or the frequency data written in the storage position is read out and set into the programmable divider of the PLL circuit, whereby preset channel selection is performed through tuning with respect to the frequency indicated by the read-out frequency data.

In the conventional preset tuner, however, there is an inconvenience in that, generally, it is possible to store frequency data only in the number equal to the number of channels, so that if there are broadcast waves to be received the number of which is more than the number of channels, it is necessary to operate a tuning key to tune in to a broadcast wave the frequency data of which is not stored.

To solve this problem, there is a preset tuner in which storage positions in a memory corresponding to preset keys of all channels can be switched in one and the same reception band by a switching key. By operating the switching key, it is therefore possible to preset-select different broadcast stations in one and the same reception band by operating a preset key of one and the same channel, so that it is possible to increase the number of channels which can be subjected to preset-selection. However, if the number of preset-selectable channels is increased simply, it is difficult to know where the frequency data of a desired broadcast station is stored, so that it is troublesome to operate for the selection of the desired broadcast station. particularly, if frequency data of a plurality of broadcast stations in one and the same network broadcasting the same programs are stored in advance, it has been impossible, by simple operation, to perform preset-selection for one broadcast station in a good receiving condition among the plurality of broadcast stations in the same network. Devices which can do this automatically are known, for instance from EP-A-403744 but they normally require specially coded radio transmissions (RDS) and can lead to unwanted and annoyingly frequent frequency switching in a clattered, high fading environment. Furthermore, control of the user over the stored data is poor or non-existant.

It is therefore an object of the present invention to provide a preset tuner according to claim 1 by which one broadcast station in a good receiving condition can be obtained, by simple operation, through preset-selection among a plurality of broadcast stations in one and the same network.

In order to accomplish the above object, a preset tuner according to the present invention is characterized by comprising: tuning means for tuning in to a frequency in accordance with supplied frequency data; a plurality of preset keys provided so as to be equal in number to a plurality of channels to thereby designate one of the plurality of channels; a memory having storage positions for storing a plurality of frequency data for every channel; means for judging, when one of the plurality of preset keys is operated, as to whether the operation of the one preset key is finished within a predetermined time or not; means for detecting, when the operation of the one preset key is finished within the predetermined time, the number of times of operating the one preset key after another preset key is operated; means for designating one of the plurality of storage positions in the memory corresponding to one of the channels designated by operating the one preset key in accordance with the detected number of times of operating the one preset key; writing means for writing frequency data supplied to the tuning means into the one designated storage position in the memory when the operation of the one preset key is not finished within the predetermined time; and means for reading frequency data from the one designated storage position in the memory and for supplying the frequency data to the tuning means when the operation of the one preset key is finished within the predetermined time.

**In the drawings:**
Fig. 1 is a block diagram illustrating an embodiment of the present invention.
Fig. 2 is a diagram illustrating a frequency data table.
Fig. 3 is a flow chart illustrating the operation of a microprocessor in a tuner in Fig. 1.
Fig. 4 is a flow chart illustrating a continued portion of the operation of the microprocessor in Fig. 3.
Fig. 5 is a diagram illustrating an example of display in a display unit.

An embodiment of the present invention will be described in detail with reference to the drawings.

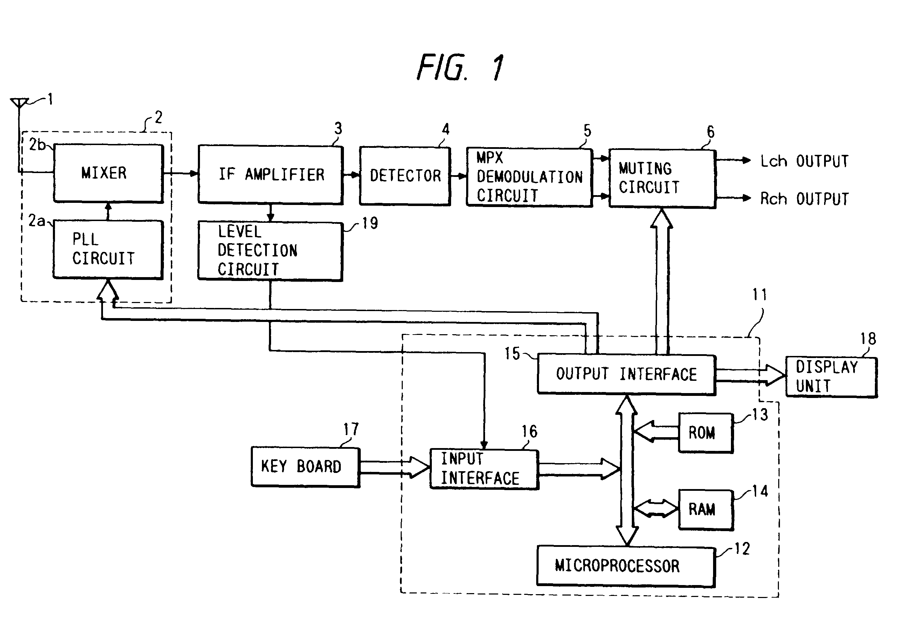

Fig. 1 shows a tuner according to an embodiment of the present invention. In this tuner, a desired station is selected by a front end 2 acting as a tuning means among broadcast waves received by an antenna 1, the broadcast wave of the desired station is converted to an intermediate frequency (IF) signal, and then the IF signal is supplied through an IF amplifier 3 to a detector 4. The front end 2 obtains, by means of a PLL synthesizer, a local oscillation signal to be supplied to a mixer 2b. The PLL synthesizer uses a PLL circuit 2a including a programmable divider, and the dividing ratio of the programmable divider is controlled by a controller 11, which will be described later, so that the channel selection operation is performed. The detection output of the detector 4 is supplied to a multiplex (MPX) demodulation circuit 5 so that the detection output is separated into audio signals for L (left) and R (right) channels, in the case of stereo broadcasting. The audio signals L and R are outputted to a muting circuit 6. The output signals of the muting circuit 6 are outputted as reproduced audio signals. The muting circuit 6 is controlled by the controller 11.

The controller 11 is a microcomputer constituted by a microprocessor 12, an ROM 13, an RAM 14, an output interface 15, an input interface 16 and a clock generator (not-shown). The microprocessor 12, the ROM 13, the RAM 14, the output interface 15 and the input interface 16 are connected with each other through a bus. The RAM 14 is a non-volatile memory, or is backed up so that stored contents are not erased at the time of turning off a power supply of the tuner. A key board 17 and a display unit 18 provided with a liquid crystal display are connected to the controller 11.

Further, a level detection circuit 19 is connected to the IF amplifier 3. The level detection circuit 19 is provided for rectifying an intermediate (IF) signal to detect the level of a received signal.

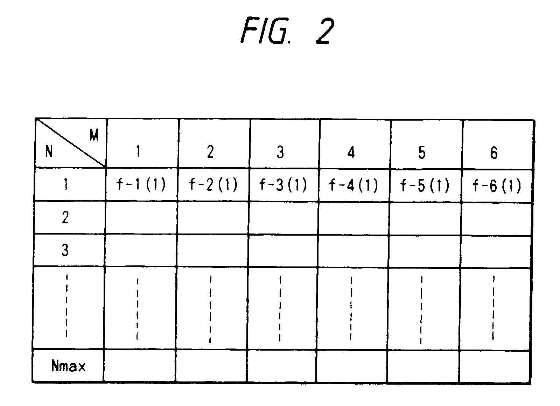

In the above configuration, a program to instruct the operation of the microprocessor 12 and fixed data are written in the ROM 13 in advance, and the microprocessor 12 starts its operation in accordance with this program if the power supply is turned on. In the RAM 14, as shown in Fig. 2, formed is a frequency data table having storage positions for storing a plurality of frequency data for each of preset channels (for example, 6 channels). In Fig. 2, M represents a preset channel number, and N represents a memory directory. Such a directory is from the first to the Nmax, and in Fig. 2, frequency data f-1(1) to f-6(1) are written in the storage positions in the first directory. Then a storage position is expressed by P-M(N) simply, and for example, the storage position in which the frequency data f-1(1) is written is expressed by P-1(1). Frequency data is to define the dividing ratio of the programmable divider (not-shown) in the PLL circuit 2a, so that if frequency data is set in the programmable divider by the microprocessor 12, tuning in to the frequency corresponding to the frequency data is performed to realize a receiving operation.

The above-mentioned frequency data f-1(1) to f-6(1) are stored as fixed data in the ROM 13 in advance. These frequency data are read from the ROM 13 in the initial operation immediately after a power supply is connected to the tuner for the first time, and written into the storage positions P-1(1) to P-6(1) of the first directory in the respective channels of the frequency data table.

The key board 17 is provided with preset keys (1) to (6) equal in number to the channels for presetting reception frequencies, and keys (not-shown) such as tuning keys constituted by up and down keys for changing the reception frequency desirably. If any one of those keys is operated, a digital code corresponding to the operated key is supplied to the microprocessor 12 through the input interface 16, so that the microprocessor 12 can judge the operated key.

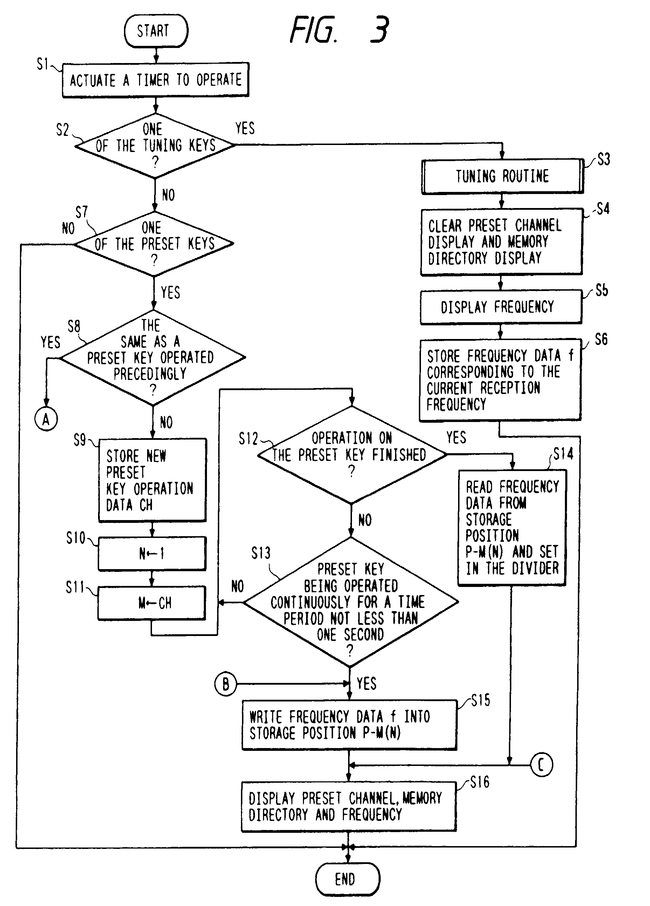

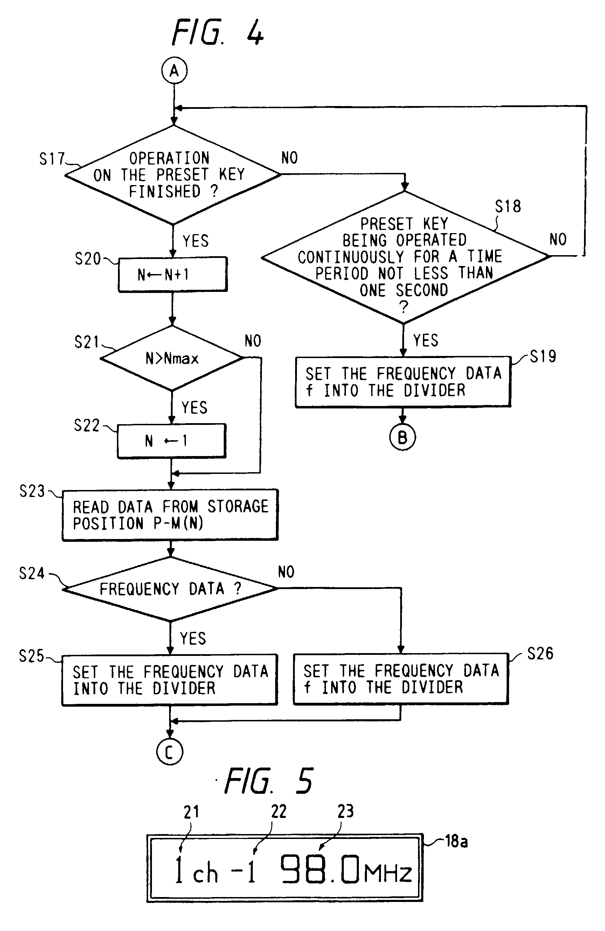

The microprocessor 12 executes a routine shown in Figs. 3 and 4 by an interruption processing when there is a key operation in a receiving condition. In this routine, first, the microprocessor 12 actuates a timer (not-shown) in the controller 11 to operate (Step S1). This timer is used for one-second time counting which will be described later. After actuating the timer, the microprocessor 12 judges whether the operated key is one of the tuning keys or not (Step S2), and if it is proved that one of the tuning keys is operated, the microprocessor 12 executes a tuning routine to change the reception frequency in accordance with the operation of the tuning key (Step 53). In the tuning routine, although not shown, the frequency data corresponding to the current reception frequency set in the programmable divider of the PLL circuit 2b is made to be f, and the microprocessor 12 judges whether the up key of the tuning keys is operated or not. If the up key is operated, the microprocessor 12 adds a predetermined value Δf (for example, a value corresponding to 100 kHz as a variation of the frequency) to the frequency data f, and sets the value of the result of addition to the programmable divider as new frequency data f. If the up key is not operated, the microprocessor 12 judges that the down key is operated, subtracts the predetermined value Δf from the frequency data f, and sets the value of the result of subtraction to the programmable divider as new frequency data f.

After executing the tuning routine, the microprocessor 12 clears preset channel display and memory directory display (Step S4), and displays a current reception frequency (Step S5), in the display unit 18. The preset channel display shows a channel number selected by operating one of the preset keys, and the current reception frequency is a frequency corresponding to the frequency data set in the programmable divider. The microprocessor 12 supplies the display unit 18 with data for stopping the preset channel display and the memory directory display, and frequency data. Consequently, the display unit 18 makes the liquid crystal display 18a delete preset channel display 21 and memory directory display 22 shown in Fig. 5, and change frequency display 23 into a new frequency. After executing Step S5, the microprocessor 12 makes the RAM 14 store frequency data f corresponding to the current reception frequency set in the programmable divider in a predetermined storage position of the RAM 14 (Step S6).

If the microprocessor 12 judges, in Step S2, that one of the tuning keys is not operated, the microprocessor 12 judges whether any one of the preset keys is operated or not (Step S7). If any preset key is not operated, the microprocessor 12 finishes this routine, or detects the operation of any other key to perform a processing operation corresponding to the operated key though not shown. For example, if a seek key (not-shown) is operated, the microprocessor 12 performs an operation to change the reception frequency and stop it at a frequency at which a received signal can be obtained with the electric field intensity not less than a predetermined level. On the other hand, if any one of the preset keys is operated, the microprocessor 12 judges whether the operated preset key is the same as a preset key operated precedingly or not (Step S8). If a preset key is operated, a digital code indicating the preset key can be obtained as preset key data CH from the key board 17 while the preset key is operated, so that the microprocessor 12 judges whether the preset key operation data is coincident with preset key operation data CH-1 indicating a preset key operated precedingly or not. If the operated preset key is different from the preset key operated precedingly, the microprocessor 12 makes the RAM 14 or a register (not-shown) in the microprocessor 12 store new preset key operation data CH (Step S9). Consequently the preset key operation data CH stored in Step S9 is read out as CH-1 at the time of executing Step S8 in the next time, and compared with preset key operation data CH obtained from the key board 17. After executing Step S9, the microprocessor 12 sets 1 as the variable N (Step S10), makes the variable M equal to preset key operation data CH (Step S11), and judges whether the operation on the operated preset key is finished or not (Step S12). If the operation on the preset key is not yet finished, the microprocessor 12 judges, from the time counting state of the above-mentioned timer, whether the operated preset key is being operated continuously for a time period not less than one second or not (Step S13). Here, Step S12 or Step S17 which will be described later is executed before one second has been passed since this routine is started. If the operation on the preset key is finished within a time period less than one second, the microprocessor 12 reads frequency data from a storage position P-M(N) of the frequency data table corresponding to the preset key operation data CH and sets the frequency data in the programmable divider of the PLL circuit 2a (Step S14). That is, frequency data is read from a storage position P-M(1) of the frequency data table. For example, if the preset key operation data CH indicates the preset key (1) of the first channel, frequency data is read from the storage position P-1(1), or if the preset key (3), frequency data is read from the storage position P-3(1), so that a frequency according to the read-out frequency data is received. On the other hand, if the preset key is operated for a time period not less than one second, the microprocessor 12 writes frequency data f of the current reception frequency into a storage position P-M(N) corresponding to the preset key operation data CH (Step S15). That is, frequency data of the current reception frequency is written into a storage position P-M(1) of the frequency data table. The variable M is a channel number of an operated preset key. After executing Step S14 or S15, the microprocessor 12 makes the display 18a of the display unit 18 display a preset channel, a memory directory and a frequency (Step S16). The microprocessor 12 sends channel data, directory data and frequency data to the display unit 18, so that the display 18a of the display unit 18 displays the preset channel display 21 and the memory directory display 22, and changes the frequency display 23 to a new frequency.

If it is proved in Step S8 that the operated preset key is the same as the preset key operated precedingly, the microprocessor 12 judges whether the operation on the preset key is finished or not in the same manner as in Step S12 (Step S17). If the operation on the preset key is not yet finished, the microprocessor 12 judges, from the time counting state of the above-mentioned timer, whether the operated preset key is being operated for a time period not less than one second (Step S18). If the preset key is being operated for a time period not less than one second, the microprocessor 12 reads frequency data f and sets the frequency data f into the programmable divider of the PLL circuit 2a (Step S19), going to Step S15 to write the frequency data f into a storage position P-M(N) corresponding to preset key operation data CH. IF the operation on the preset key is finished for a time period less than one second, the microprocessor 12 adds "1" to the variable N (Step S20), and judges whether the variable N exceeds the maximum value Nmax or not (Step S21). If N≤Nmax, the microprocessor 12 goes to Step S23 immediately, and if N>Nmax, the microprocessor 12 sets "1" as the variable N (Step S22), and goes to Step S23. In Step S23, the microprocessor 12 reads data from the storage position P-M(N) of the frequency data table, and in next Step S24, the microprocessor 12 judges whether the read data is a frequency data or not. That is, the microprocessor 12 reads data in the storage position P-M(N) and judges whether the read data is a value within a predetermined range (a value to be taken as frequency data). If the data of the storage position P-M(N) is frequency data, the microprocessor 12 sets the frequency data into the programmable divider of the PLL circuit 2a (Step S25). If the data of the storage position P-M(N) is data other than frequency data, the microprocessor 12 reads the frequency data f stored in the RAM 14 and sets the frequency data f into the programmable divider of the PLL circuit 2a (Step S26).

Assuming that the frequency data f set in the programmable divider of the PLL circuit 2a by operating one of the tuning keys is fa, after operation on the tuning key, if the preset key (2) is operated and the operation has been finished within one second, the frequency data f-2(1) is read from the storage position P-2(1) and set into the programmable divider of the PLL circuit 2a, so that a frequency corresponding to the frequency data f-2(1) is received. Next, if the preset key (2) is operated again and the operation is finished within one second, data is read from the storage position P-2(2). If this read data is frequency data, the data is set into the programmable divider, and a frequency corresponding to the new frequency data is received. However, if the read data is data other than frequency data since there is no written data in the storage position P-2(2), the frequency data fa is read from the RAM 14 and set into the programmable divider, so that a frequency corresponding to the frequency data fa is received. Then if the preset key (2) is operated and the operation is continued for a time period not less than one second, the frequency data fa is stored as f-2(2) in the storage position P-2(2).

By such a tuner according to the present invention as described above, a network (a group of broadcast stations having the same contents of broadcast programs) is allocated for every preset channel, and frequencies for a plurality of broadcast stations in one and the same network are stored in one preset channel in advance by operating a tuning key and a preset key, so that if the receiving condition at a frequency which is being received at present becomes worse during running of a vehicle on which this tuner is mounted, it is possible to switch the receiving condition into another receiving condition of another broadcast wave in the same network indicating a higher reception signal level, by only operating the preset key of the current selection channel. For example, it is assumed that there are broadcast stations in the same network in adjacent areas a, b and c respectively, and that the respective broadcast frequencies for the broadcast stations in the areas a, b and c are 98.0 MHz, 100.0 MHz, and 102.0 MHz. In addition, it is assumed that this network is assigned in the first channel, and that the frequency data indicating 98.0 MHz, 100.0 MHz and 102.0 MHz are written into the storage positions P-1(1), P-1(2) and P-1(3) of the frequency data table respectively. Then, it is further assumed that a user operates the preset key (1) while driving a vehicle in the area a so that the user is listening to a broadcast program at 98.0 MHz, and if the vehicle comes from the area a into the area b thereafter, the user can perform preset selection, only by operating the preset key (1), to 100.0 MHz which is the broadcast frequency for the broadcast station in the area b. Further, if the vehicle comes from the area b into the area c thereafter, the user can perform preset selection, only by operating the preset key (1) once again, to 102.0 MHz which is the broadcast frequency for the broadcast station in the area c.

In the above-mentioned embodiment, although the predetermined time is set to one second, it is not limited to this value. For example, it may be set to 0.5 second.

Further, when frequency data is set into the programable divider of the PLL circuit 2b, the muting circuit 6 may be operated until a new tuning operation has been perfectly completed so as not to output audio signals including noise.

According to the present invention, a memory having storage positions for storing a plurality of frequency data for every channel is provided, a desired one of a plurality of preset keys is operated, the number of times of operating the one preset key after operating another preset key is detected in the case where the operation on the one preset key is finished within a predetermined time, and one storage position corresponding to the detected number of times of operation is designated among a plurality of storage positions of the memory corresponding to a channel designated by the operation on the one preset key. If the operation on the one preset key is not finished within the predetermined time, the frequency data supplied to a tuning means is written into the designated storage position, while if the operation on the one preset key is finished within the predetermined time, frequency data is read from the designated storage position and supplied to the tuning means, so that preset channel selection is performed. Therefore, if frequency data for broadcast stations in the same network are written in a plurality of storage positions for one channel in advance, when the receiving condition at a frequency which is being currently received becomes worse, it is possible to switch to the receiving condition of another broadcast wave in the same network indicating a higher reception signal level only by operating a preset key of the current selected channel. That is, it is possible to perform preset selection of one broadcast station which can be received in a better receiving condition among a plurality of broadcast stations in of the same network.

In addition, if the intensity of the received electric field of a broadcast wave which is being received is detected all the time, when the intensity is decreased to a value not more than a predetermined value so that the receiving condition becomes worse, it is possible to automatically switch to the reception of another broadcast wave in the same network the frequency data of which is stored.

## Claims

1. A preset tuner comprising:
tuning means for tuning in to a frequency in accordance with supplied frequency data;
a plurality of preset keys provided so as to be equal in number to a plurality of channels to thereby designate one of said plurality of channels;
a memory having storage positions for storing a plurality of frequency data for every channel;
characterised in that said preset tuner includes
means for judging, when one of said plurality of preset keys is operated, as to whether the operation of said one preset key is finished within a predetermined time or not;
means for detecting, when the operation of said one preset key is finished within said predetermined time, the number of times of operating said one preset key after another preset key is operated;
means for designating one of said plurality of storage positions in said memory corresponding to one of said channels designated by operating said one preset key in accordance with the detected number of times of operating said one preset key;
writing means for writing frequency data supplied to said tuning means into said one designated storage position in said memory when the operation of said one preset key is not finished within said predetermined time; and
means for reading frequency data from said one designated storage position in said memory and for supplying said frequency data to said tuning means when the operation of said one preset key is finished within said predetermined time.

2. The preset tuner according to Claim 1, further comprising variable means for changing frequency data in accordance with manual operation and for supplying the changed frequency data to said tuning means, and means for renewing and storing frequency data supplied from said variable means to said tuning means, wherein said writing means writes the renewed and stored frequency data into said one designated storage position in said memory.

3. The preset tuner according to Claim 2, wherein said variable means includes tuning keys constituted by an up key for increasing the tuning frequency and a down key for decreasing the tuning frequency.

4. The preset tuner according to Claim 1, wherein said tuning means comprises a mixer and a phase locked loop circuit including a programable divider for supplying a local oscillation signal to said mixer, a dividing ratio of said programable divider being controlled by said frequency data for performing a tuning operation.

5. The preset tuner according to Claim 1, wherein said memory is a non-volatile memory.

6. The preset tuner according to Claim 1, wherein said memory is backed up so that stored contents are not erased at the time of turning off a power supply of said tuner.

7. The preset tuner according to Claim 1, further comprising display means for displaying a channel designated by operating said one preset key, a directory corresponding to said one storage position designated by said designating means, and a current receiving frequency.

8. The preset tuner according to Claim 1, wherein a plurality of frequency data for broadcast stations in one and the same network are stored in a plurality of storage positions for one channel in said memory.

## Patentansprüche

1. Tuner mit Voreinstellung, der umfaßt:
eine Abstimmeinrichtung, die nach Maßgabe zugeführter Frequenzdaten auf eine Frequenz abstimmt;
eine Mehrzahl von Voreinstelltasten, bereitgestellt, um in der Zahl gleich einer Mehrzahl von Kanälen zu sein, um dadurch einen aus der Mehrzahl von Kanälen zu bezeichnen;
einen Speicher mit Speicherstellen, um eine Mehrzahl von Frequenzdaten für jeden Kanal zu speichern,
dadurch gekennzeichnet, daß der Tuner mit Voreinstellung umfaßt
eine Einrichtung, die, wenn eine aus der Mehrzahl von Voreinstelltasten betätigt wird, entscheidet, ob die Betätigung der einen Voreinstelltaste innerhalb einer vorbestimmten Zeit beendet wird oder nicht;
eine Einrichtung, die, wenn die Betätigung der einen Voreinstelltaste innerhalb der vorbestimmten Zeit beendet wird, die Zahl von Malen der Betätigung der einen Voreinstelltaste nach dem Betätigen einer anderen Voreinstelltaste ermittelt;
eine Einrichtung, die eine aus der Mehrzahl von Speicherstellen in dem Speicher, die einem der durch Betätigen der einen Voreinstelltaste bezeichneten Kanäle entspricht, nach Maßgabe der ermittelten Zahl von Malen der Betätigung der einen Voreinstelltaste bezeichnet;
eine Schreibeinrichtung, die der Abstimmeinrichtung zugeführte Frequenzdaten in die eine bezeichnete Spelcherstelle in dem Speicher schreibt, wenn die Betätigung der einen Voreinstelltaste nicht innerhalb der vorbestimmten Zeit beendet wird, und
eine Einrichtung, die Frequenzdaten aus der einen bezeichneten Speicherstelle in dem Speicher liest und die Frequenzdaten der Abstimmeinrichtung zuführt, wenn die Betätigung der einen Voreinstelltaste innerhalb der vorbestimmten Zeit beendet wird.

2. Tuner mit Voreinstellung nach Anspruch 1, der des weiteren eine variable Einrichtung, die Frequenzdaten nach Maßgabe manueller Betätigung ändert und die geänderten Frequenzdaten der Abstimmeinrichtung zuführt, und eine Einrichtung umfaßt, die Frequenzdaten, die der Abstimmeinrichtung von der variablen Einrichtung zugeführt werden, erneuert und speichert, wobei die Schreibeinrichtung die erneuerten und gespeicherten Frequenzdaten in die eine bezeichnete Speicherstelle in dem Speicher schreibt.

3. Tuner mit Voreinstellung nach Anspruch 2, bei dem die variable Einrichtung Abstimmtasten umfaßt, die durch eine Aufwärtstaste zum Erhöhen der Abstimmfrequenz und eine Abwärtstaste zum Vermindern der Abstimmfrequenz gebildet werden.

4. Tuner mit Voreinstellung nach Anspruch 1, bei dem die Abstimmeinrichtung einen Mischer und eine Phasenregelschleifenschaltung einschließlich eines programmierbaren Tellers umfaßt, die dem Mischer ein lokales Schwingungssignal zuführt, wobei ein Teilungsverhältnis des progammierbaren Teilers durch die Frequenzdaten gesteuert wird, um einen Abstimmvorgang durchzuführen.

5. Tuner mit Voreinstellung nach Anspruch 1, bei dem der Speicher ein nichtflüchtiger Spelcher ist.

6. Tuner mit Voreinstellung nach Anspruch 1, bei dem der Speicher gesichert ist, so daß die gespeicherten Inhalte beim Abschalten einer Stromversorgung des Tuners nicht gelöscht werden.

7. Tuner mit Voreinstellung nach Anspruch 1, der des weiteren eine Anzeigeeinrichtung umfaßt, die einen durch Betätigen der einen Voreinstelltaste bezeichneten Kanal, ein Verzeichnis, das der einen durch die Bezeichnungseinrichtung bezeichneten Speicherstelle entspricht, und eine augenblickliche Empfangsfrequenz anzeigt.

8. Tuner mit Voreinstellung nach Anspruch 1, bei dem eine Mehrzahl von Frequenzdaten für Sendestatlonen in ein und demselben Netzwerk in einer Mehrzahl von Speicherstellen für einen Kanal in dem Speicher gespeichert werden.

## Revendications

1. Récepteur radio à présélections, comprenant:
un moyen d'accord pour s'accorder sur une fréquence, en accord avec des données de fréquence fournies;
plusieurs touches de présélection prévues de manière à être en nombre égal à celui de plusieurs canaux, pour ainsi désigner un parmi lesdits plusieurs canaux;
une mémoire présentant des positions d'enregistrement, pour enregistrer plusieurs données de fréquence pour chaque canal;
caractérisé en ce que ledit récepteur radio à présélection comprend
un moyen pour estimer, lorsqu'une desdites différentes touches de présélection est actionnée, si le fonctionnement de ladite touche de présélection est terminé ou non après une durée prédéterminée;
un moyen pour détecter, lorsque l'actionnement de ladite touche de présélection est terminé après ladite durée prédéterminée, le nombre des actionnements de ladite touche de présélection après qu'une autre touche de présélection a été actionnée;
un moyen pour attribuer l'une desdites différentes positions d'enregistrement de ladite mémoire, correspondant à celui desdits canaux qui est désigné par l'actionnement de ladite touche de présélection, en accord avec le nombre détecté des actionnements de ladite touche de présélection;
un moyen d'écriture pour écrire dans ladite position désignée d'enregistrement de ladite mémoire, des données de fréquence fournies audit moyen d'accord, lorsque l'actionnement de ladite touche de présélection n'est pas terminé après ladite durée prédéterminée; et
un moyen pour lire des données de fréquence dans ladite position désignée d'enregistrement de ladite mémoire, et pour fournir lesdites données de fréquence audit moyen d'accord lorsque l'actionnement de ladite touche de présélection est terminé après ladite durée prédéterminée.

2. Récepteur radio à présélections selon la revendication 1, comprenant en outre un moyen de modification, pour modifier les données de fréquence en accord avec un actionnement manuel, et pour fournir les données de fréquence modifiées audit moyen d'accord, et un moyen pour renouveler et enregistrer des données de fréquence fournies par ledit moyen modifiable audit moyen d'accord, dans lequel ledit moyen d'écriture écrit les données de fréquence renouvelées et enregistrées dans ladite position désignée d'enregistrement de ladite mémoire.

3. Récepteur radio à présélections selon la revendication 2, dans lequel ledit moyen de modification comprend des touches d'accord, constituées d'une touche de montée pour augmenter la fréquence d'accord et d'une touche de descente pour diminuer la fréquence d'accord.

4. Récepteur radio à présélections selon la revendication 1, dans lequel ledit moyen d'accord comprend un mélangeur et un circuit à boucle de verrouillage de phase comprenant un diviseur programmable pour fournir un signal d'oscillation locale audit mélangeur, un rapport de division dudit diviseur programmable étant réglé par lesdites données de fréquence pour effectuer une opération d'accord.

5. Récepteur radio à présélections selon la revendication 1, dans lequel ladite mémoire est une mémoire non volatile.

6. Récepteur radio à présélections selon la revendication 1, dans lequel ladite mémoire est dupliquée, de telle sorte que le contenu enregistré ne soit pas effacé lorsque l'alimentation en énergie dudit récepteur radio est coupée.

7. Récepteur radio à présélections selon la revendication 1, comprenant en outre un moyen d'affichage pour afficher un canal désigné par l'actionnement de ladite touche de présélection, un répertoire correspondant à ladite position d'enregistrement désignée par lesdits moyens d'attribution, et une fréquence en cours de réception.

8. Récepteur radio à présélections selon la revendication 1, dans lequel les différentes données de fréquence de stations émettrices d'un seul et même réseau sont enregistrées dans ladite mémoire en plusieurs positions d'enregistrement d'un canal.
